# EUROPEAN PATENT APPLICATION

(11) **EP 2 594 995 A1**
(43) Date of publication of application: **22.05.2013**
(21) Application number: 11189329.3
(22) Date of filing: 16.11.2011
(51) Int. Cl.: G03F 7/00

(54) **A method for providing a nanopattern of metal oxide nanostructures on a substrate**

(71) Applicant: University College Cork, Cork City (IE)
(72) Inventor: Morris, Michael, Midleton, Co. Cork (IE); Borah, Dipu, Co. Cork Cork (IN); Goshal, Tandra, Co. Cork Cork (IN); Mokarian, Parvaneh, Co. Cork Cork (IN)
(74) Representative: Purdylucey Intellectual Property

(57) **Abstract**

A method for providing a nanopattern of periodically ordered metal oxide nanostructures on a substrate is described. The method comprises the steps of providing a microphase separated block copolymer as a thin film on a substrate, the block copolymer comprising a first polymer having an affinity for a cations of the metal and a second polymer having a lower affinity for the cations than the first polymer, and selectively incorporating a salt of the metal cation into the first polymer of the block copolymer by means of a solvation process prior to or after formation of the microphase separated block copolymer. The block copolymer film is then treated to oxidise the metal ion salt and remove the polymers leaving a nanopattern of metal oxide nanostructures on the substrate.

## Description

### Technical Field

The invention relates to a method of providing a nanopattern of metal oxide nanostructures on a substrate. The invention also relates to a substrate bearing a nanopattern of metal oxide nanostructures. The invention also relates to the use of the nanopattern of metal oxide nanostructures as a resist for pattern transfer to a substrate via an etch process.

### Introduction

Highly dense, well-ordered arrays of functional nanostructured materials at substrate surfaces is not only scientifically interesting but also technologically important area due to potential applications in optoelectronic devices, information storage, photonic materials, catalysis and sensors. Most of these applications require the nanostructures to be chemically stable, uniform in size, well-dispersed and chemically/structurally controlled. Further, the spatial locations of the nanopattern over an extended area should be defined as precisely as possible.

The fabrication of nanopatterned materials with ultra-small dimensions has been accomplished by several methods, including self-organisation, ultra-violet or e-electron beam lithography, X-ray lithography or imprint lithography. Amongst these methods, block copolymers present an interesting class of materials due to their potential to self-assemble into highly regular structures of mesoscopic dimensions, bridging the gap between molecular and macroscopic scales. Thin films of cylinder or lamellar (one block arranged in a hexagonally arranged series of parallel cylinders or alternating lamellae within a matrix of the other block(s)) forming diblock copolymers have excited particularly interest because; if the patterns can be oriented perpendicularly to the substrate surface, selective etching procedures can remove one of the blocks and result in the formation of a nanoporous film. It should be noted that there is a challenge of fabricating these films with long range order due to the presence of topological defects such as dislocations and disclinations which limit the persistence lengths of the spontaneously formed microdomains.

### Summary of the Invention

The invention is based on selective incorporation of a metal oxide precursor into one polymer of a phase separated di-block copolymer film, and the subsequent oxidation of the precursor and removal of the polymers to leave a nanopattern of metal oxide nanostructures. Thus, when the block copolymer film is disposed on a silicon substrate, the invention results in the nanopattern of metal oxide nanostructures being formed on the surface of the silicon substrate. The nanostructures are generally nanodots, although other shapes are possible, for example lines.

Thus, in a first aspect, the invention provides a method for providing a nanopattern of metal oxide nanostructures, ideally periodically ordered, metal oxide nanostructures, on a substrate comprising the steps of:
- providing a microphase separated block copolymer as a thin film on a surface, the block copolymer comprising a first polymer having an affinity for metal cations and a second polymer having a lower affinity for cations than the first polymer;
- selectively incorporating a metal ion salt into the first polymer of the block copolymer by means of a solvation process prior to or after formation of the microphase separated block copolymer; and
- treatment of the block copolymer film to oxidise the metal ion salt and remove the polymers leaving metal oxide nanostructures on the substrate.

In a second aspect, the invention provides a substrate bearing an array of inorganic metal oxide nanostructures arranged thereon in an equally spaced periodically ordered arrangement, in which the nanostructures are of uniform size, and wherein the density of the nanostructures on the surface is at least 1 x 10⁸ nanostructures cm⁻².

In a third aspect, the invention relates to a method of transferring a pattern of nanodots or nanolines to a substrate by means of an etch process comprising the steps of providing a nanopattern of metal oxide nanostructures on the substrate according to a method of the invention, and using the nanopattern of metal oxide nanostructures as a resist during pattern transfer via the etch process.

In a fourth aspect, the invention provides an intermediate structure for use in the formation of a substrate of the invention and comprising a substrate bearing a phase-separated block copolymer as a thin film, the block copolymer comprising a first polymer having an affinity for metal cations and a second polymer having a lower affinity for cations than the first polymer, wherein the first polymer selectively incorporates a metal ion salt. Preferably, the first polymer is PEO and the second polymer is PS.

The invention also relates to a hexagonal or linear array of thermally stable metal oxide nanostructures formed on a substrate.

### Brief Description of the Figures

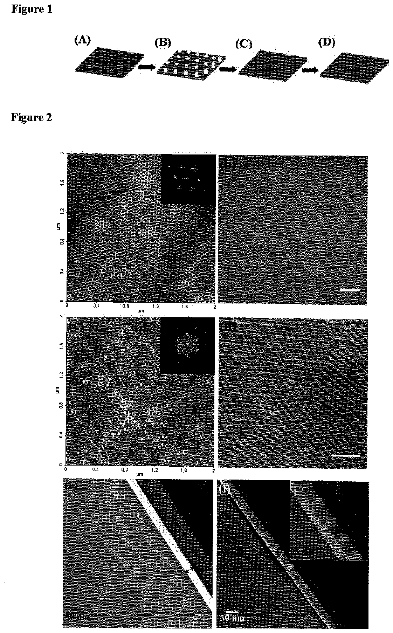

**Figure 1****.** Schematic illustration of the fabrication of oxide nanodots. (A) Highly ordered PS-b-PEO thin film prepared by solvent annealed process. (B) Nanoporous template produced by chemical etching of PEO. (C) metal oxide precursor moves into the pores after spin coating the precursor solution. (D) oxide dots remain after UV/Ozone treatment.
**Figure 2****.** (a, c) Atomic force microscoy (AFM), (b, d) scanning electron microscopy (SEM) and (e, f) cross sectional TEM images of PS-b-PEO thin film solvent annealed in toluene/water at 50°C and nanoporous template after PEO removal respectively. Insets of a and c shows the corresponding FFT pattern. Scale bar: 200 nm.

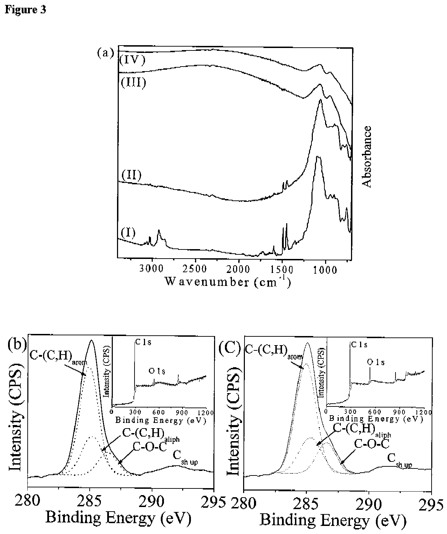

**Figure 3.** (a) FTIR spectra of (I) PS-PEO hexagonal dot patterns after solvent annealing, (II) nanoporous PS template after PEO removal, (III) copper oxide nanodots after UV/Ozone treatment and (IV) copper oxide nanodots after UV/ozone along with annealing. (b, c) C1s core level spectrum of PS-PEO before and after ethanol treatment respectively. In sets of (b, c) shows the corresponding survey spectra.

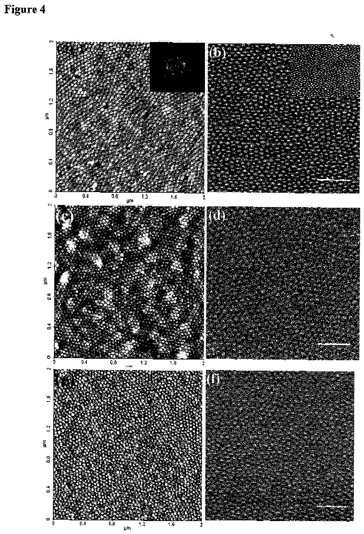

**Figure 4****.** AFM and SEM images of hexagonal ordered different oxide nanodots after UV/Ozone treatment. (a) and (b) iron oxide; (c) and (d) cerium oxide; and (e) and (f) copper oxide nanodots. Insets of (a) shows the corresponding FFT pattern. Inset of (b) shows iron oxide nanodots annealed at 800°C for 1h. Scale bar: 200 nm.

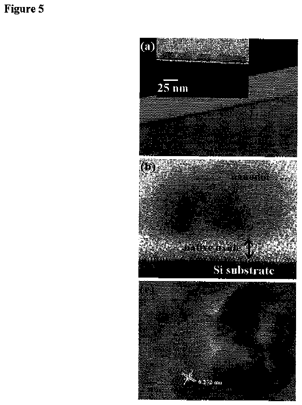

**Figure 5.** (a) TEM cross sectional image of iron oxide nanodots. Inset shows the higher magnification image. (b) cross sectional HRTEM image of a single nanodot and (c) HRTEM image of iron oxide nandots.

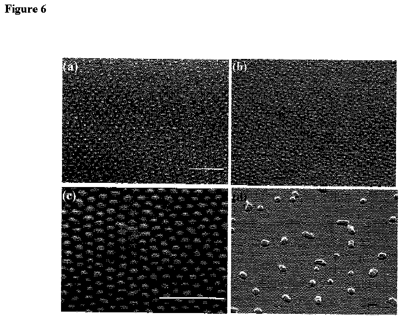

**Figure 6****.** SEM images of different sized copper oxide nanodots for different concentrations of precursor (a) 0.3%, (b) 0.5% (c) 0.7% and (d) 1.2%. Scale bar: 100 nm.

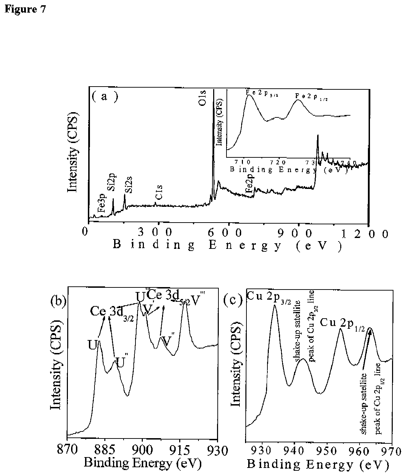

**Figure 7.** (a) XPS survey spectra recorded from the iron oxide nanodots on Si substrate after annealing at 800°C for 1h. Inset shows high resolution spectrum for Fe 2p core level revealed Fe₂O₃ phase. (b) Ce 3d spectra depicts CeO₂ phase and (c) Cu 2p core level spectra describes CuO phase.

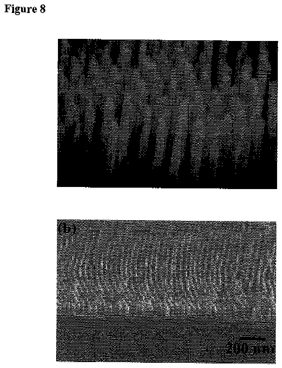

**Figure 8****.** The SEM images of silicon substrates that have been subject to pattern transfer via formation of iron oxide nanostructures formed by the method described herein. (a) vertical cylinders formed from a nanodot pattern and (b) lines from a lamellar structure.

### Detailed Description of the Invention

The invention relates to a methodology to produce oxide nanopatterns based on selective incorporation of a metal ion into one polymer of a phase separated block copolymer by means of a simple solvation process rather than complex chemical co-ordination between metal precursors and one of the polymer blocks and typically does not require the creation of a nanoporous template or the use of sol-gel methods. The method employs a phase separated block copolymer having a first polymer that has an affinity for metal cations and a second polymer that has a lower affinity for metal cations then the first polymer.

The term "the first polymer has an affinity for the metal ion" should be understood to mean that the metal ion can be incorporated into the polymer by a simple solvation process.

The term "solvation process" should be understood to mean that the metal ions are added into the selected polymer block via a solution process which is based around the solvent entering the selected polymer and incorporating the metal ions.

The first polymer is selected from polyethylene oxide, polylactide, polybutylene oxide, polyacrylic acid, polyvinyl alcohol, any polylactone.

The second polymer is suitably selected from polystyrene (PS), polybutadiene, polymethyl methacrylate, polyisoprene, and any polyolefin.

In one embodiment, the first polymer is polyethylene oxide (PEO) and the second polymer is selected from the group consisting of polystyrene (PS).

In a preferred embodiment of the invention, the block copolymer comprises polystyrene and polyethylene oxide, ideally polystyrene-b-poly(ethylene oxide) di-block copolymer. Other block copolymers suitable for the invention include any amphiphilic block copolymer system that undergoes microphase separation and suitable examples are polystyrene-b-polylactide, polystyrene-b-polybutylene oxide, polymethyl methacrylate-b-polyacrylic acid, polybutadiene-b-polyethylene oxide.

Typically, microphase separation in the block copolymer is provided by treating the block copolymer to an annealing process in a toluene/water mixed solvent vapour environment to induce microphase separation of polymers. When PEO and PS re employed, annealing results in hexagonal packing of PEO cylinders oriented perpendicular to the substrate.

The term "periodically ordered" should be understood to mean that the system exhibits a pattern formed that has both short range and long range order. In this way the local pattern is reproduced so that the spacing of features is uniform in any chosen direction across the substrate.

The term "metal oxide" as employed herein should be understood to mean a chemical compound containing a metal and an anion of oxygen typically in a -2 state. Generally, the metal is selected from a transition metal (i.e. iron, copper, silver, nickel, aluminium, tungsten, silicon cadmium) or a lanthanide (i.e. cerium), although other metals may be employed in the present invention.

The term "metal ion salt" should be understood to mean an ionic compound comprising a salt-forming metal cation and a salt-forming cation. Examples of salt-forming anions include nitrates, nitrites, phosphates, sulphates, chlorides and carbonates. Suitably, the metal ion salt is a metal nitrate, for example iron (III) nitrate nonahydrate, cerium nitrate hexahydrate, and copper nitrate hemipentahydrate.

The metal ion salt is suitably incorporated into the first polymer of the block copolymer by exposure of a pre-cast block copolymer to a solution of solvent and the metal ion salt. Suitably, the solvent is ethanol, although other alcohols may be employed. Preferably, the solution of metal ion salt is spin-coated onto the copolymer. Ideally, the copolymer is provided in the form of a film.

Alternatively, the metal ion salt may be incorporated into the first polymer prior to formation of the block copolymer, simply by mixing the metal ion salt and the polymer.

The phase separated block copolymer film is generally immersed in alcohol, i.e. ethanol, for a suitable period of time, typically for at least one hour and generally from 1-36, 1-24, 1-18 or 1-12 hours, prior to treatment of the block copolymer to remove the polymers. Ideally, the immersion step is carried out for 1-24 hours at 35-45 degrees C, ideally 1-18 hours at 38-42 degrees C.

In one embodiment, the treatment of the block copolymer film to oxidise the metal ion salt and remove the polymers is carrried out in a single step. Suitably, the treatment is a UV/ozone treatment. Other treatments suitable for removal of polymer include thermal treatment and oxidative etching.

Suitably, the metod involves a heat treatment step in which the metal oxide nanostructures are fixed on the surface by treatment at an elevated temperature, i.e. greater then 100, 200, 300, 400, 500, 600, 700, 800, 900 or 1000 degrees C for at least 10 minutes, for example 800 degrees C for one hour, 1000 degrees C for 30 minutes or 400 degrees C for 12 hours.

In a preferred embodiment of the invention, the substrate is a silicon substrate, for example a silicon wafer, although other substrate such as glass, quartz and SiO2 are also suitable.

The invention also relates to a method of transferring a pattern to a substrate by means of an etch process comprising the steps of providing a nanopattern of metal oxide nanostructures on the substrate according to a method of the invention, and using the nanopattern of metal oxide nanostructures as a resist during pattern transfer via the etch process. Thus, the nanopattern of metal oxide nanostructures may be employed as a resist during pattern transfer via an etch process. Various types of etch processes will be well known to those skilled in the art, including liquid phase (wet) etching (including anisotropic wet etching) and gas phase phase (dry) etching including plasma processes and especially reactive ion etching and inductively coupled plasma (Borah et al., J. Phys. D. Appl. Phys. 44. 2011). Electron beam and helium ion beam etching can also be combined with a resist pattern to facilitate pattern transfer to a substrate. The techniques described here can be applied to all these well-established techniques.

The invention also provides a substrate bearing an array of inorganic metal oxide nanostructures arranged thereon in an equally spaced periodically ordered arrangement, in which the nanostructures are of uniform size, and wherein the density of the nanostructures on the surface is at least 1 x 10⁸ nanostructures cm⁻², preferably at least 1 x 10¹⁰ nanostructures cm⁻², and ideally at least 2 x 10¹⁰ nanostructures cm⁻². The nanostructures generally have a diameter of from 10-50nm, preferably 15-30nm, more preferably 20-30nm. Suitably, the centre to centre distance of the nanostructures is 30-60nm, preferably 40-50nm. Characterisation techniques such as atomic force microscopy, secondary electron microscopy, and helium ion microscopy, are employed.

Typically, the nanostructures are nanodots having a flattened dome shape, such that the edges of the nanodot are not less than one fifth of the height at the centre. This ensures the materials can act as good resists across the whole of their structure. However, other types of nanostructures are envisaged, for example lines.

The invention also provides an intermediate structure for use in the formation of a substrate of the invention and comprising a substrate bearing a phase-separated block copolymer as a thin film, the block copolymer comprising a first polymer having an affinity for metal cations and a second polymer having a lower affinity for cations than the first polymer, wherein the first polymer selectively incorporates a metal ion salt. Ideally, the first polymer is PEO and the second polymer is PS, and the metal is ideally selected from iron, copper and cerium.

Broadly, the invention relates to a methodology to produce oxide nanopatterns based on a simple solvation process rather than complex chemical co-ordination between metal precursors and one of the polymer blocks and does not require the creation of a nanoporous template or the use of sol-gel methods. In one aspect the methodology is based around the use of solvent-induced microphase separation in PS-b-PEO thin films which have controlled structure orientation. It takes advantage of the marked difference in the chemical functionality of PS and PEO to allow selective metal ion inclusion and avoids the need to selectively remove the PEO block for material deposition. This is important because selective removal of the PEO block is a challenge. Different methods (viz. ozonolysis, UV degradation, reactive ion etching and chemical etching) are generally used for selective removal of the minority block in BCPs but the poor degradability of PEO prevents the direct generation of nanopores from PS-b-PEO. Removal of the minor component via selective solvents is a very promising strategy for generating pores, but there is lack of reports of the removal of PEO by simple steps without affecting the ordered structure of thin film.

A schematic diagram of the fabrication process is shown in Figure 1. PS-b-PEO was spin-coated from toluene (a good solvent for both PS and PEO) onto a Si(100) substrate. The film was annealed in toluene/water mixed solvent vapour environment to induce microphase separation of polymers with hexagonal packing of PEO cylinders oriented perpendicular to the substrate (Figure 1A). The film was then treated with ethanol a selective solvent for PEO in the conditions used. The ethanol is expected to swell the PEO molecules but is unlikely to substantially dissolve the PS-PEO because of the covalent bonds linking the blocks. There are changes to the film as a result of the ethanol-PEO interactions (Figure 1B) but the cylinder-to-cylinder distance and diameter of the cylinders are unchanged from that of solvent annealed film. The chosen metal ion solution was the spin coated onto the film and diffuses within the pores driven by the capillary force (Figure 1C). UV/Ozone treatment was carried out to convert the precursor into oxide as well as for complete degradation of the residual polymers (Figure 1D).

Solvent annealing in a mixed toluene/water environment was used to induce long range-ordering and favour vertical cylinder orientation. Here, since the room temperature vapour pressure of toluene (Pᵥₚ = 0.0342 bar) and water (Pᵥₚ = 0.0313 bar) are similar it is that swelling and increased mobility in both blocks is achieved and the similarity of the PS-toluene and H₂O-PEO solvent parameters should negate the strong segregation of PS to the surface.²⁶ Figure 2a shows an AFM image of the film (40 nm thick as determined by ellipsometry) with the expected vertically orientated hexagonal arrangement expected. The minor component, PEO, forms the cylindrical domains (darker contrast in AFM) and the major component, PS, constitutes the matrix (lighter contrast in AFM). The measured average centre-to-centre cylinder spacing is 42 nm with a PEO cylinder diameter is 19.3 nm. The strong multiple peaks in the FFT pattern shown in the inset of figure 2a confirms microphase separated structure with highly ordered hexagonal arrangement of PEO cylinders. SEM image in figure 2b also depicts long range ordering of the PS-PEO thin film. Different substrates such as glass, quartz and SiO₂ were employed to investigate the influence of polymer/substrate interface on structure formation. No clear difference was observed on the substrates, suggesting that the pairwise surface tensions of the films on all substrate systems are more or less similar to each other.

When the solvent annealed films were immersed in ethanol at 40°C for 15 hours clear modification of the film is achieved although the structural arrangement and dimensions are unchanged. The AFM image (figure 2c) shows some increase in the phase contrast and an increase in long-rage order. This is also indicated by the Fourier transform of the AFM image (inset figure 2c) where six-point patterns with multiple higher order reflections are observed characteristic of exceptional long-range order. Also, the SEM image contrast was enhanced by ethanol exposure as seen in figure 2d. No thickness loss was observed after the ethanol treatment as measured by optical ellipsometry.

Oxide nanodots are formed, for example, by simple inclusion of metal ions (or example in a metal nitrate or other salt ethanol solution) into the PEO component. PEO is known to have good affinity with cations and, without being bound by theory, it is believed that swelling of PEO by ethanol allows rapid incorporation of the metal cations. The effectiveness of this simple solution mediated inclusion is again good evidence for the presence of PEO. Had complete removal of the PEO been achieved, it would be highly unlikely that significant metal uptake would occur because the PS matrix would be hydrophobic and the concentration of metal in solution is rather low.

After metal ion inclusion, UV/ozone treatment was preferably carried out immediately so as to remove any solvent, oxidize and cross-link metal ions forming oxide and remove the organic part simultaneously. This behaviour is confirmed by the FTIR data of copper oxide nanodots presented in figure 3a(III and IV). The low frequency peaks are dramatically modified decreasing in intensity and shifting in frequency consistent with decreases in polymer content. Two features can be seen at 1084 and 1010 cm⁻¹ which can be assigned to transverse optical phonon mode in -Si-O-Si-³² and the Si-O-Cu phonon mode.³³ Figure 4 shows the AFM and SEM images well-ordered oxide nanodots of various metal oxides formed after the UV/ozone treatment. From the AFM and SEM images, the measured average centre-to-centre nanodot distance is 42 nm and the FFT pattern shown in the inset of Figure 4a confirms the hexagonal ordering of the nanodots. This confirms these have been produced via direct templating of the PS-b-PEO film. Figure 4a (AFM) and 4b (SEM tilt image) shows iron oxide nanoparticles (0.4 wt% iron nitrate ethanol solution) of average diameter 24 nm. The height measured by ellipsometry is 8 nm (in good agreement with TEM data, see below). Thus, each iron oxide feature is hemispherical with a height significantly smaller than the diameter and can properly be described as nanodots. The density of the nanodots on the substrate was approximately 4.2 x 10¹⁰ nanodots cm⁻². In order to examine the route is applicable to prepare well-ordered nanodots of different oxides; the same process was repeated with several inorganic precursors. AFM and SEM images (figure 4c and 4d) shows cerium oxide nanodots with a similar long range order as the iron oxide materials and with average diameter 25 nm (1 wt% ethanol cerium nitrate solution). Also, data following spin-coating of a 0.5 wt% ethanol-copper nitrate solution is also shown and this generates the same size features as those of cerium oxide (figures 4e and 4f).

The nanodots formed according to a method of the invention are well-adhered to the substrate and thermally robust. Typical data is presented in the inset of figure 4b which shows iron oxide nanodots after air calcination at 800 °C for 1 h. SEM image shown in the inset of figure 4b confirms the ordered structure of the nanodots even after annealing. The only effect of heating recorded was a slight reduction in the average diameter and height consistent with high temperature densification and from all the materials studied it can be concluded that the thermal stability of the nanodots depends on the material properties of the nanodot material and the substrates. This is the first report of hexagonal array of highly thermally stabilized oxide nanodots.

The structure of these systems is exemplified further by TEM (figure 5). The cross-sectional TEM image shows a well-ordered array of nanodots (figure 5a). The adhesion of the materials is reflected in integrity of the structures during FIB treatment and the lack of any interfacial cracks etc. at the base of the particles. The same hemispherical top-flat base is seen for all imaged nanodots. The average diameter of the nanodots is 24 nm and height is 9 nm when 0.4 wt% nitrate solution was used in the preparation consistent with measurments made above. The high resolution TEM (HRTEM) image of one of the nanodots (figure 5b) shows the nanodot-surface interface. The nanodots are supported on a 1.7 nm thick amorphous native at the silicon substrate surface. This HRTEM image revealed crystalline nature of the nanodots. No impurity or planar defects were observed. The crystalline nature of the iron oxide nanodots after annealing at 800 °C was analysed by TEM. The nanodots on Si substrate were scratched by a sharp edge blade and disperse into ethanol for the preparation of TEM grid. HRTEM image shown in figure 5c confirms the single crystalline nature of the nanodots. The lattice fringes were regularly separated with a spacing of 0.252 nm, which agrees well with the (110) lattice spacing of rhombohedral hematite.

The diameter and height of the nanodots can, of course, be varied by changing the polymer molecular weight and composition. However, the simplest approach is to vary the concentration of precursor solution which changes the size of the nanodots without changing their spacing or structural arrangement. This is illustrated in figures 6a, b and c, where well-ordered copper oxide nanodot arrays can be seen. The average diameters 18, 24 and 30 nm generated form 0.3, 0.5 and 0.7 wt% ethanol-copper nitrate solutions. It can also be estimated from the SEM images that the height of the nanodots is increasing with higher precursor concentration.

The materials were further studied by XPS to assess the surface composition and chemical structures of the nanodots following 800°C calcinations. All the spectra were corrected according to the C1s peak positioned at 285 eV in emptily. Figure 7a shows typical XPS survey spectrum of iron oxide nanodots and confirms indicates the presence of Si, O, C and Fe. The C1s feature is relatively small and demonstrates effective removal of carbon species during processing (as seen above by FTIR). Its size is consistent with adventitious material formed by adsorption and other contamination during sample preparation. High resolution Fe 2p data were used to assess the hematite or magnetite form of the nanodots. The Fe 2p core level spectrum (figure 7a inset) consists of two sharp peaks associated with Fe 2p_{3/2} at 711.3 eV and Fe 2p_{1/2} at 725.1 eV accompanied by satellite structures (8 eV shift) on their high binding energy side. These data are consistent with the existence of Fe⁺³ ions only. Thus, XPS analysis confirms the formation of phase pure α-Fe₂O₃ without any polymer residues. Survey spectrum obtained from cerium oxide and copper oxide nanodots on Si substrates also indicates pure oxides without any trace of polymers (data not shown). The XPS Ce 3d spectrum is illustrated in figure 7b for the cerium oxide nanodots after annealing. There are six peaks assigned in the spectrum which are complicated by a process known as shake-down and the features are labelled according to the convention established by Burroughs³⁷. The peaks U, U", U"' and V, V", V"' refer to 3d_{3/2} and 3d_{5/2} respectively and are characteristic of Ce(IV) 3d final states. The high binding energy doublet V"'/U"' at 916.6 eV and 898.4 eV are assigned to the final state of Ce(IV) 3d⁹4f⁰ O 2p⁶. Doublets V"/U" at 907.3 eV and 888.6 eV were attributed to the hybridization state of Ce(IV) 3d⁹4f¹ O 2p⁵, and doublets V/U at 901.0 eV and 882.5 eV correspond to the state of Ce(IV) 3d⁹4f² O 2p⁴. These data indicate that sintering in air results in a Ce(IV) oxide, consistent with a CeO₂ fluorite oriented structure. The XPS spectrum of copper oxide nanodots on Si substrate, Cu 2p core level region is shown in figure 7c. The Cu 2p_{3/2} and Cu 2p_{1/2} peaks centred at 933.7 and 953.6 eV (splitting of 19.9 eV) respectively can be attributed to the presence of the Cu²⁺ chemical state as an indication for formation of CuO.³⁸ Moreover, the shake-up satellite peaks of the Cu 2p_{3/2} and Cu 2p_{1/2} at 942.4 and 962.6 eV respectively (∼ 9 eV shift) confirmed formation of Cu²⁺ on the surface.³⁹ Note that the Cu 2p features for CuO and Cu(OH)₂ appear almost at the same binding energy but the possibility of forming the hydroxide phase has not been considered because of the high temperature calcination immediately prior to analysis.

In summary, a simple, generic and cost-effective (compared to lithographic methods) route was demonstrated to fabricate well-ordered arrays of inorganic oxide nanodots by using microphase separated self-assembly of diblock copolymers. It can be applied to a number of oxide and substrate materials. The nanodots formed have uniform sizes, shape and are structurally arranged in a mimic of the original self-assembled BCP pattern. The dots are formed by selective inclusion of a metal ion solution in the hydrophilic cylinders of the microphase separated structure. The nanodots inclusion does not compromise the BCP structure. In a preferred embodiment, UV/ozone treatments were used to convert the metal ion modified structure into the nanodot pattern. This was effective in forming oxide as well as removing the organic template. The size of the oxide nanodots can be controlled by variation of the metal ion solution concentration. The nanodots have good thermal stability and show strong adherence to the surface to high temperatures. The phase purity and compositions of the oxides was confirmed by XPS analysis. The structure, crystallinity and thermal stability of these materials coupled to the ease of production may make them useful in many applications. This process could be extended to a wide range of size and spacing of features by use of similar BCPs of varying composition and block sizes.

### Experimental Section:

Experimental Section. A polystyrene-b-poly(ethylene oxide) (PS-b-PEO) diblock copolymer was purchased from Polymer Source and used without further purification (number-average molecular weight, *M*ₙ, PS = 42 kg mol⁻¹, *M*ₙ, PEO = 11.5 kg mol⁻¹, *M*_{w}/*M*ₙ = 1.07, *M*_{w}: weight-average molecular weight). Substrates used were reclaimed 8" silicon (100) wafers with a native oxide layer. Substrates were cleaned by ultrasonication in acetone and toluene for 30 min each and dried under a nitrogen stream. PS-b-PEO was dissolved in toluene to yield 0.9 wt% polymer solution at room temperature and this solution was aged for 12 hours. The PS-b-PEO thin film was fabricated by spin coating the polymer solution at 3000 rpm for 30 sec on Si wafer. The film was exposed to toluene/water (50:50, v/v) mixed vapour placed at the bottom of a closed vessel kept at 50°C for 1h under static vacuum to induce mobility and allow microphase separation to occur. Separate reservoirs were used for each solvent to avoid azeotropic effects. The resultant phase separated film was immersed in ethanol at 40°C for 15h. After the desired time period, the substrate was taken out from the solvent quickly and dried under nitrogen stream. For the fabrication of different oxide nanodots, nitrate precursors were used. Here we have used iron (III) nitrate nonahydrate (Fe(NO₃)₃,9H₂O), cerium nitrate hexahydrate (Ce(NO₃)₃,6H₂O) and copper nitrate hemipenta hydrate (Cu(NO₃)₂,2.5H₂O). Different concentrations of precursors were dissolved in ethanol and spin coated onto the nanoporous film. After drying, UV/Ozone treatment was used in order to oxidize the precursor as well as to remove polymer residues. The oxide nanodots substrates were placed in a pre-heated oven at 800°C for 1 hour to check the thermal stability of the nanodots.

Surface morphologies were imaged by scanning probe microscopy (SPM, Park systems, XE-100) in tapping mode and scanning electron microscopy (SEM, FEI Company, FEG Quanta 6700). The film thicknesses were measured by optical ellipsometer (Woolam M2000) and electron microscopy. Samples were prepared for TEM cross sectional imaging with an FEI Helios Nanolab 600i system containing a high resolution Elstar™ Schottky field-emission SEM and a Sidewinder FIB column and were further imaged by transmission electron microscopy (TEM, JEOL 2100). X-Ray photoelectron spectroscopy (XPS) experiments were conducted on a Thermo K-alpha machine with Al K_{α} X-ray source operating at 72 W. FTIR spectra were recorded on infrared spectrometer (Nicolet 6700).

The invention is not limited to the embodiments hereinbefore described which may be varied in construction and detail without departing from the spirit of the invention.

## Claims

1. A method for providing a nanopattern of periodically ordered metal oxide nanostructures on a substrate comprising the steps of:
- providing a microphase separated block copolymer as a thin film on a substrate, the block copolymer comprising a first polymer having an affinity for a cations of the metal and a second polymer having a lower affinity for the cations than the first polymer;
- selectively incorporating a salt of the metal cation into the first polymer of the block copolymer by means of a solvation process prior to or after formation of the microphase separated block copolymer; and
- treatment of the block copolymer film to oxidise the metal ion salt and remove the polymers leaving a nanopatterns of metal oxide nanostructures on the substrate.

2. A method as claimed in Claim 1 in which the block copolymer comprises polystyrene and polyethylene oxide.

3. A method as claimed in Claim 1 or 2 in which the metal ion salt is a metal nitrate.

4. A method as claimed in any preceding Claim in which the metal ion salt is incorporated into one of the polymers of the block copolymer by exposure of a pre-cast block copolymer film to a solution of solvent and the metal ion salt.

5. A method as claimed in any of Claims 1 to 3 in which the metal ion salt is incorporated into one of the polymers prior to formation of the blcok copolymer.

6. A method as claimed in any preceding Claim in which the phase separated block copolymer film is immersed in ethanol for a period of time prior to treatment of the block copolymer to remove the polymers.

7. A method as claimed in any preceding Claim in which treatment of the block copolymer film to oxidise the metal ion salt and remove the polymers is carrried out in a single step by UV/ozone treatment.

8. A method as claimed in any preceding Claim in which the metal oxide nanostructures are fixed on the surface by treatment at an elevated temperature for at least 10 minutes.

9. A method as claimed in any preceding Claim in which the substrate is a silicon substrate.

10. A method of transferring a pattern to a substrate by means of an etch process comprising the steps of providing a nanopattern of periodically ordered metal oxide nanostructures on the substrate according to a method of any of Claims 1 to 9, and using the nanopattern of equally-spaced periodically ordered metal oxide nanostructures as a resist during pattern transfer via the etch process.

11. A substrate bearing an array of inorganic metal oxide nanostructures arranged thereon in an equally spaced periodically ordered arrangement, in which the nanostructures are of uniform size, and wherein the density of the nanostructures on the surface is at least 1 x 10⁸ nanostructures cm⁻².

12. A substrate as claimed in Claim 11 in which the density of the nanostructures on the surface is at least 1 x 10¹⁰ nanostructures cm⁻².

13. A substrate as claimed in any of Claims 11 to 12 in which the metal oxide is an iron oxide, a copper oxide or a cerium oxide.

14. An intermediate structure for use in the formation of a substrate of any of Claims 11 to 13 and comprising a substrate bearing a phase-separated block copolymer as a thin film, the block copolymer comprising a first polymer having an affinity for metal cations and a second polymer having a lower affinity for cations than the first polymer, wherein the first polymer selectively incorporates a metal ion salt.

15. An intermediate structure as claimed in Claim 14 in which the first polymer is PEO and the second polymer is PS.
